# EUROPEAN PATENT APPLICATION

(11) **EP 2 120 262 A1**
(43) Date of publication of application: **18.11.2009**
(21) Application number: 08251729.3
(22) Date of filing: 16.05.2008
(51) Int. Cl.: H01L 23/498

(54) **Structure of packaging substrate and method for making the same**

(71) Applicant: Phoenix Precision Technology Corporation, Hsin-Chu (TW)
(72) Inventor: Hu, Wen-Hung, Hsin-feng, Hsinchu (TW)
(74) Representative: Tranter, Andrew David

(57) **Abstract**

A structure of a packaging substrate and a method for making the same are disclosed, wherein the structure comprises: a substrate body having a circuit layer on the surface thereof, wherein the circuit layer has a plurality of conductive pads which are each formed in a flat long shape to enhance the elasticity of circuit layout; a solder mask disposed on the substrate body and having a plurality of openings corresponding to and exposing the conductive pads, wherein the openings are each formed in a flat long shape; and a metal bump disposed in each of the openings of the solder mask and on each of the corresponding conductive pads.

## Description

### BACKGROUND OF THE INVENTION

### 1. Field of the Invention

The present invention relates to a structure of a packaging substrate and a method for making the same and, more particularly, to a structure of a packaging substrate which can increase the number of wires between neighboring conductive pads or reduce the pad pitch, and a method for making the same.

### 2. Description of Related Art

In general, a conventional semiconductor package structure is made such that a semiconductor chip is mounted by its back surface on the top surface of the substrate, then the package structure is finished through wire bonding, or a semiconductor chip is mounted by the active surface thereof on the top surface of the substrate, thereby finishing a flip-chip package structure, followed by placing solder balls on the back surface of the substrate to provide electrical connections for an electronic device like a printed circuit board.

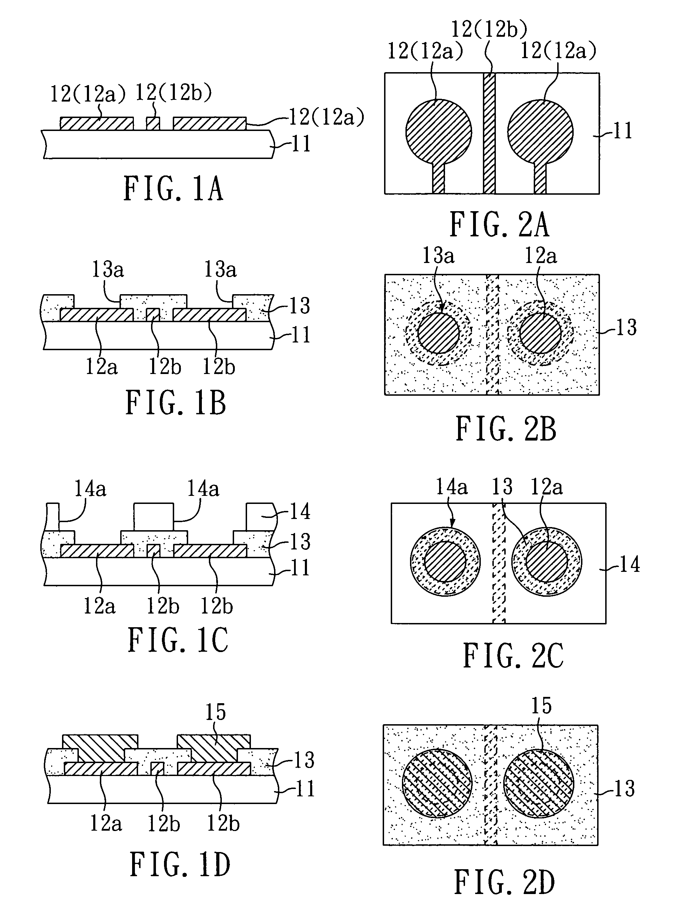

FIGS. 1A to 1D show a method for making a conventional structure of a packaging substrate, and FIGS. 2A to 2D show the top views thereof. As shown in FIGS. 1A and 2A, a packaging substrate 11 is provided having a patterned metal layer as a circuit layer 12 formed thereon, and the metal layer is generally formed by stacking a seed layer and a copper layer on the seed layer. The circuit layer 12 comprises a plurality of conductive pads 12a and circuits 12b. As shown in FIG. 2A, in the conventional structure of the packaging substrate, the conductive pads 12a are usually fabricated in a circular shape, and a wire 12b for connecting other conductive pad is formed between the neighboring conductive pads 12a to enhance the density of circuit layout. However, the space between the neighboring conductive pads 12a allows only one wire 12b to be formed therein, due to the certain pad pitch and the limitation from the pad width and the shift of alignment.

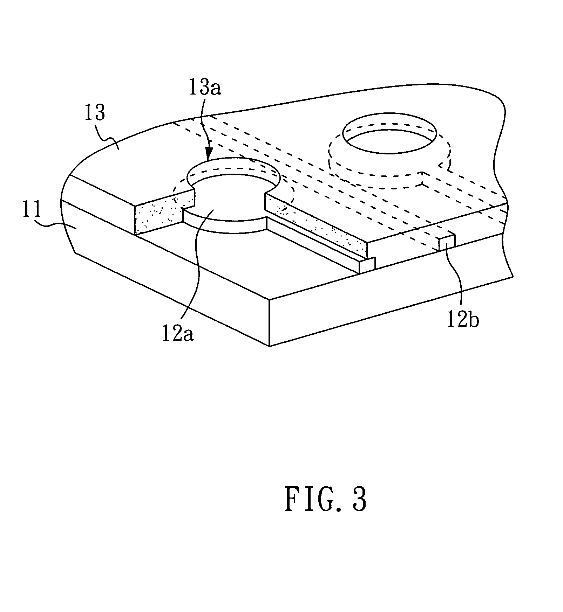

Subsequently, as shown in FIG. 1B, the packaging substrate 11 is covered by a solder mask 13 made of photosensitive resin, followed by forming a plurality of openings 13a in the solder mask 13 corresponding to and exposing the conductive pads 12a by photolithography process. So far, the size of the openings 13a in the solder mask 13 is usually smaller than that of the conductive pads 12a, due to considering alignment. Please refer to FIGS. 2B and 3 (FIG. 3 shows the three-dimensional view of FIGS. 1B and 2B). In the conventional structure of a packaging substrate, the openings 13a of the solder mask 13 are formed in a circular shape, and the size of the openings 13a is slightly smaller than that of the conductive pads 12a (shown in dotted lines). However, the size of the circular openings 13a of the solder mask 13 is limited by the process ability of the development technology. If the size of the circular openings 13a of the solder mask 13 is smaller than the limit size of the process ability of the contemporary technology, it is difficult to achieve the precise pattern by that technology.

Then, as shown in FIG. 1C, a seed layer (not shown in the figure) and a patterned resist layer 14 are formed on the solder mask 13 in sequence.
The patterned resist layer 14 has a plurality of openings 14a corresponding to and exposing the conductive pads 12a. As shown in FIG. 2C, the size of the openings 14a in the resist layer 14 is larger than that of the openings 13a in the solder mask 13, and the openings 14a are in a circular shape.

Finally, as shown in FIG. 1D, a metal bump 15 is formed in each of the openings 14a in the resist layer 14 by electroplating; and then, the patterned resist layer 14 and the seed layer (not shown in the figure) covered by the patterned resist layer 14 are removed so as to accomplish the conventional structure of a packaging substrate. The metal bump 15 is higher than the surface of the solder mask 13, and has a protrusion extending out of the openings 13 a of the solder mask 13. As shown in FIG. 2D, the protrusion of the metal bump 15 is in a circular shape.

Thereby, in the conventional structure, the space between the neighboring conductive pads 12a allows only one wire 12b to be formed therein, due to the certain pad pitch and the limitation from the pad size. In addition, the size of the openings 13a of the solder mask 13 is limited by the process ability of developing circular openings, and thus the feasibility of reducing the pitch between the metal bumps 15 is also limited.

However, in the development of electronics, the design trend of a semiconductor package structure is towards high integration and miniaturization. On the reason aforementioned, it is an important issue to enhance the density of circuit layout or reduce the pad pitch within a restricted space.

### SUMMARY OF THE INVENTION

The present invention provides a structure of a packaging substrate, wherein the conductive pads and the openings of the solder mask are each in a flat long shape to increase the number of wires between the neighboring conductive pads or reduce the pad pitch so as to satisfy the requirements of high integration and miniaturization.

The present invention provides a structure of a packaging substrate, comprising: a substrate body having a circuit layer on the surface thereof, wherein the circuit layer has a plurality of conductive pads which are each formed in a flat long shape to enhance the elasticity of circuit layout; a solder mask disposed on the substrate and having a plurality of openings corresponding to the conductive pads, wherein the openings are each formed in a flat long shape; and a metal bump disposed in each of the openings of the solder mask and on each of the corresponding conductive pads, wherein the material of the metal bump can be selected from the group consisting of copper, tin, nickel, chromium, titanium, copper/chromium alloy, and tin/lead alloy.

In the structure of the present invention, the shape of the conductive pads can be any flat long shape. Preferably, the conductive pads are formed in a rectangular shape or an elliptical shape.

In the structure of the present invention, the shape of the openings in the solder mask can be any flat long shape. Preferably, the openings in the solder mask are formed in a rectangular shape or an elliptical shape.

In the structure of the present invention, preferably, the size of the openings in the solder mask is smaller than that of the conductive pads in consideration of the alignment shift in the process for forming the openings in the solder mask corresponding to the conductive pads.

In the structure of the present invention, the metal bump is higher than the surface of the solder mask and has a protrusion extending out of the openings of the solder mask. The protrusion of the metal bump can be in any shape. Preferably, the protrusion of the metal bump is formed in a circular shape to provide a joint that can supply uniform bonding force.

The structure of the present invention can further comprise at least one wire disposed between the neighboring conductive pads to enhance the density of circuit layout. When the structure of the present invention is employed in a multi-layered packaging substrate, the number of layers of the built-up structures of the packaging substrate can be reduced for cost saving, resulting from the feasibility of increasing the number of wires between the neighboring conductive pads.

In addition, the present invention also provides a method for making a structure of a packaging substrate to enhance the number of wires available in the space between the neighboring conductive pads or reduce the pad pitch. The method for making a structure of a packaging substrate of the present invention comprises: forming a circuit layer on a substrate body, wherein the circuit layer has a plurality of conductive pads, and the conductive pads are each formed in a flat long shape to enhance the elasticity of circuit layout; forming a solder mask on the substrate body, and forming a plurality of openings in the solder mask corresponding to and exposing the conductive pads, wherein the openings of the solder mask are each formed in a flat long shape; forming a seed layer on the surfaces of the solder mask and the conductive pads; forming a resist layer on the solder mask and forming a plurality of openings in the resist layer corresponding to and exposing the openings of the solder mask; forming a plurality of metal bumps in the openings of the resist layer and the corresponding openings of the solder mask by electroplating; and removing the resist layer and the seed layer covered by the resist layer.

In the method of the present invention, the shape of the conductive pads can be any flat long shape. Preferably, the conductive pads are formed in a rectangular shape or an elliptical shape.

In the method of the present invention, the shape of the openings in the solder mask can be any flat long shape. Preferably, the openings in the solder mask are formed in a rectangular shape or an elliptical shape.

In the method of the present invention, preferably, the size of the openings in the solder mask is smaller than that of the conductive pads in consideration of the alignment shift in the process for forming the openings in the solder mask corresponding to the conductive pads.

In the method of the present invention, the circuit layer can further comprise at least one wire disposed between the neighboring conductive pads to enhance the density of circuit layout. When the structure of the present invention is employed in a multi-layered packaging substrate, the number of layers of the built-up structures of the packaging substrate can be reduced for cost saving, resulting from the feasibility of increasing the number of wires in the space between the neighboring conductive pads.

Other objects, advantages, and novel features of the invention will become more apparent from the following detailed description when taken in conjunction with the accompanying drawings.

### BRIEF DESCRIPTION OF THE DRAWINGS

FIGS. 1A to 1D are cross-section views of a conventional method for making a structure of a packaging substrate;
FIGS. 2A to 2D are top views of FIGS. 1A to 1D;
FIG. 3 is a three-dimensional view of FIG. 2B;
FIGS. 4A to 4D are cross-section views of a method for making a structure of a packaging substrate of a preferred embodiment of the present invention;
FIGS. 5A to 5D are top views of FIGS. 4A to 4D;
FIG. 6 is a three-dimensional view of FIG. 5B;
FIG. 7 is a three-dimensional view of a structure of a packaging substrate of a preferred embodiment of the present invention; and
FIG. 8 is a top view of FIG. 7.

### DETAILED DESCRIPTION OF THE PREFERRED EMBODIMENT

### Embodiment 1

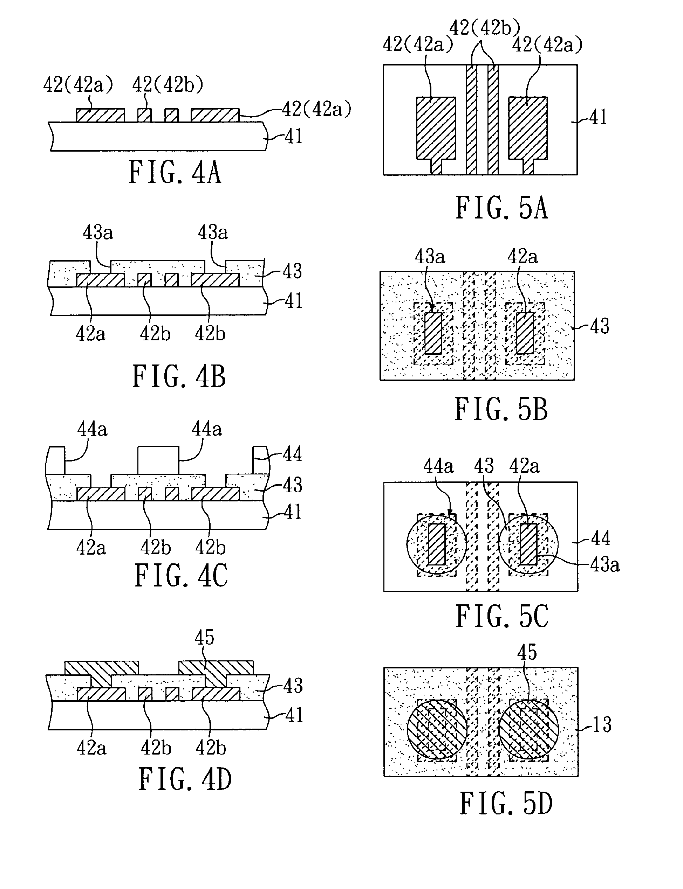

FIGS. 4A to 4D show cross-section views of making a structure of a packaging substrate, and FIGS. 5A to 5D show top views thereof. As shown in FIG. 4A, a substrate body 41 is provided, and a patterned metal layer as a circuit layer 42 is formed on the surface of the substrate body 41. In the present embodiment, the patterned metal layer is formed by stacking a seed layer and a metal layer on the seed layer. The material of the seed layer and the metal layer in the present embodiment is copper.

As shown in FIGS. 4A and 5A, the circuit layer 42 comprises a plurality of conductive pads 42a and circuits 42b. The conductive pads 42a are each formed in a rectangular (flat long) shape to enhance the elasticity of circuit layout.

In comparison to the conventional structure (as shown in FIG. 2A), the width of the conductive pad 42a is smaller than that of the conventional conductive pad 12a. Thereby, the space between the neighboring conductive pads is larger than the conventional one, while the conductive pads 42a are disposed at the same position as the conventional ones. Accordingly, one more wire can be disposed between the neighboring conductive pads (as shown in FIG. 5A) so as to enhance the density of circuit layout. Alternatively, the space between the neighboring conductive pads 42a can be reduced so as to reduce the pitch between the metal bumps (not shown in the figure) fabricated in the following process if no additional wire is needed between the neighboring conductive pads 42a.

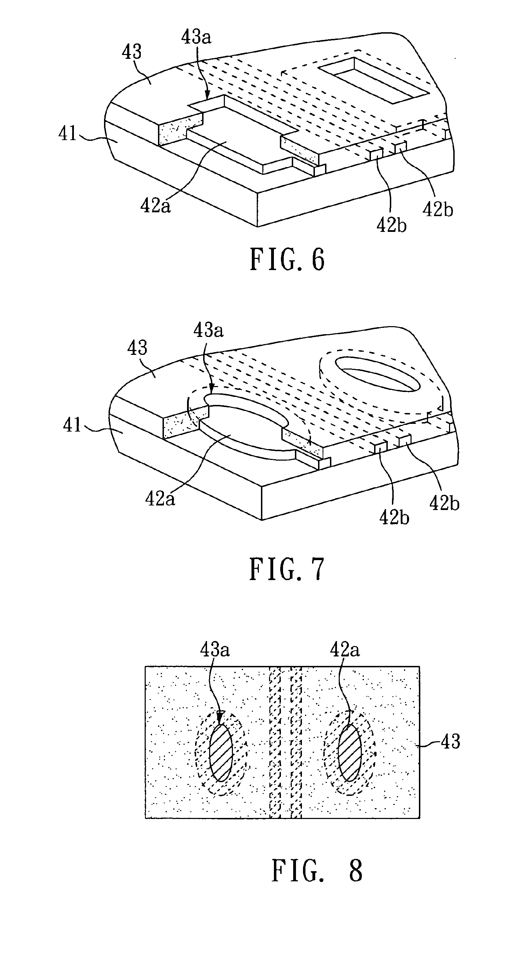

Subsequently, as shown in FIG. 4B, the substrate body 41 is covered by a solder mask 43, and then a plurality of openings 43 a are formed in the solder mask 43 corresponding to and exposing the conductive pads 42a by photolithography process. The size of the openings 43a in the solder mask 43 has to be smaller than that of the conductive pads 42a in consideration of the alignment shift. As shown in FIGS. 5B and 6 (FIG. 6 shows the three-dimensional view of FIG. 4B), the openings 43a of the solder mask 43 in the structure of the present embodiment are formed in a rectangular shape, and the size of the openings 43 a in the solder mask 43 is smaller than that of the conductive pads 42a (shown in dotted lines).

In comparison to the conventional structure (as shown in FIG. 2A), the width of the openings 43a of the solder mask 43 in the present embodiment is smaller than the diameter of the conventional openings 13a of the solder mask 13, and the length of the openings 43a of the solder mask 43 in the present embodiment is larger than the diameter of the conventional openings 13a of the solder mask 13. Since developing liquid can easily flow into flat long-shaped openings, the width of the openings 43a in the solder mask 43 can be smaller than the limit size of process ability for developing circular openings.

Next, as shown in FIG. 4C, a seed layer (not shown in the figure) and a patterned resist layer 44 are formed on the solder mask 43 in sequence. The patterned resist layer 44 has a plurality of openings 44a corresponding to and exposing the conductive pads 42a. As shown in FIG. 5C, the size of the openings 44a in the resist layer 44 is larger than that of the openings 43a in the solder mask 43, and the openings 44a of the resist layer 44 are in a circular shape.

Finally, as shown in FIG. 4D, metal bumps 45 are formed in the openings 44a of the resist layer 44 by electroplating, and then the patterned resist layer 44 and the seed layer (not shown in the figure) covered by the resist layer 44 are removed so as to accomplish the structure of the packaging substrate of the present invention. The material of the metal bump 45 can be selected from the group consisting of copper, tin, nickel, chromium, titanium, copper/chromium alloy, and tin/lead alloy. In the present embodiment, the material of the metal bump 45 is copper. The metal bump 45 is higher than the surface of the solder mask 43 and has a protrusion extending out of the openings 43a of the solder mask 43. As shown in FIG. 5D, the protrusion of the metal bump 45 is formed in a circular shape to provide a joint that can supply uniform bonding force. The conductive pads 42a (shown in dotted lines) and the openings 43a of the solder mask 43 (shown in dotted lines) are each formed in a rectangular shape. In comparison to the conventional one, since the pad width of the conductive pads 42a with the same pad pitch as the conventional ones is reduced, the space between the neighboring conductive pads 42a can be increased, and thereby the elasticity of circuit layout is enhanced. Accordingly, the structure of the packaging substrate of the present invention can enhance the density of circuit layout or reduce the pad pitch to satisfy the requirements of integration and miniaturization.

### Embodiment 2

The process of the present embodiment is similar to that of Embodiment 1, except that the conductive pads and the openings of the solder mask in the present embodiment are each formed in an elliptical shape.

Corresponding to FIGS. 4B and 5B in Embodiment 1, FIG. 7 shows the three-dimensional view of the structure of the packaging substrate of the present embodiment. The structure of the packaging substrate comprises: a substrate body 41, conductive pads 42a, circuits 42b, a solder mask 43, and openings 43a of the solder mask. FIG. 8 shows a top view of FIG. 7. The conductive pads 42a (shown in dotted lines) and the openings 43a of the solder mask 43 (shown in dotted lines) are formed in an elliptical shape.

Similarly, the conductive pads and the openings of the solder mask are each formed in a flat long shape, so as to enhance the elasticity of circuit layout, increase the number of wires between the neighboring conductive pads or reduce the pad pitch, and thus satisfy the requirements of high integration and miniaturization.

Although the present invention has been explained in relation to its preferred embodiment, it is to be understood that many other possible modifications and variations can be made without departing from the spirit and scope of the invention as hereinafter claimed.

## Claims

1. A structure of a packaging substrate, comprising:
a substrate body having a circuit layer on the surface thereof, wherein the circuit layer has a plurality of conductive pads which are each formed in a flat long shape to enhance the elasticity of circuit layout;
a solder mask disposed on the substrate and having a plurality of openings corresponding to and exposing the conductive pads, wherein the openings are each formed in a flat long shape; and
a metal bump disposed in each of the openings of the solder mask and on each of the corresponding conductive pads.

2. The structure as claimed in claim 1, wherein the conductive pads are each in one of a rectangular shape and an elliptical shape.

3. The structure as claimed in claim 1, wherein the openings of the solder mask are each in a rectangular shape or an elliptical shape.

4. The structure as claimed in claim 1, wherein the size of the openings of the solder mask is smaller than that of the conductive pads.

5. The structure as claimed in claim 1, wherein the metal bump is higher than the surface of the solder mask and has a protrusion extending out of the openings of the solder mask.

6. The structure as claimed in claim 5, wherein the protrusion of the metal bump is in a circular shape.

7. The structure as claimed in claim 1, wherein the material of the metal bump is selected from the group consisting of copper, tin, nickel, chromium, titanium, copper/chromium alloy, and tin/lead alloy.

8. The structure as claimed in claim 1, further comprising at least one wire disposed between the neighboring conductive pads.

9. A method for making a structure of a packaging substrate, comprising:
forming a circuit layer on a substrate body, wherein the circuit layer has a plurality of conductive pads, and the conductive pads are each formed in a flat long shape to enhance the elasticity of circuit layout;
forming a solder mask on the substrate body, and forming a plurality of openings in the solder mask corresponding to and exposing the conductive pads, wherein the openings of the solder mask are each formed in a flat long shape;
forming a seed layer on the surfaces of the solder mask and the conductive pads;
forming a resist layer on the solder mask and forming a plurality of openings in the resist layer corresponding to and exposing the openings of the solder mask;
forming a plurality of metal bumps in the openings of the resist layer and the corresponding openings of the solder mask by electroplating; and
removing the resist layer and the seed layer covered by the resist layer.

10. The method as claimed in claim 9, wherein the conductive pads are each formed in a rectangular shape or an elliptical shape.

11. The method as claimed in claim 9, wherein the openings of the solder mask are each formed in a rectangular shape or an elliptical shape.
